(19) Europäisches Patentamt
European Patent Office
Office européen des brevets

(11) **EP 3 578 016 B1**

(12) **EUROPÄISCHE PATENTSCHRIFT**

(45) Veröffentlichungstag und Bekanntmachung des Hinweises auf die Patenterteilung:
06.10.2021 Patentblatt 2021/40

(21) Anmeldenummer: **18756231.9**

(22) Anmeldetag: **17.08.2018**

(51) Int Cl.:
*H01L 23/62* (2006.01)   *H01L 29/06* (2006.01)
*H05K 3/34* (2006.01)   *H01L 29/32* (2006.01)
*H01L 29/36* (2006.01)   *H01L 29/739* (2006.01)
*H01L 29/861* (2006.01)   *H05K 1/11* (2006.01)
*H05K 3/24* (2006.01)   *H05K 3/28* (2006.01)
*H05K 3/30* (2006.01)

(86) Internationale Anmeldenummer:
**PCT/EP2018/072314**

(87) Internationale Veröffentlichungsnummer:
**WO 2019/057410 (28.03.2019 Gazette 2019/13)**

(54) **LEITERPLATTEN-BAUGRUPPE**

PRINTED CIRCUIT BOARD MODULE

ENSEMBLE DE CARTES DE CIRCUITS IMPRIMÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.09.2017 DE 102017121791**

(43) Veröffentlichungstag der Anmeldung:
**11.12.2019 Patentblatt 2019/50**

(73) Patentinhaber: **Ebm-Papst St. Georgen GmbH & CO. KG**
**78112 St. Georgen (DE)**

(72) Erfinder:
• **EHLERS, Volker**
**78112 St. Georgen (DE)**
• **SANDER, Ralf-Michael**
**78112 St. Georgen (DE)**

(74) Vertreter: **Staeger & Sperling**
**Partnerschaftsgesellschaft mbB**
**Sonnenstraße 19**
**80331 München (DE)**

(56) Entgegenhaltungen:
DE-A1- 2 154 958    DE-A1- 2 154 958
DE-A1-102011 082 537    JP-A- 2007 173 687
JP-A- 2007 173 687

• **Wikipedia: "Electroless nickel immersion gold", Wikipedia , 21. Juni 2017 (2017-06-21), XP002785813, Gefunden im Internet: URL:https://en.wikipedia.org/w/index.php?title=Electroless_nickel_immersion_gold&direction=next&oldid=786803373 [gefunden am 2018-10-16]**
• **ANONYMOUS: "Electroless nickel immersion gold", INTERNET CITATION, 21 June 2017 (2017-06-21), XP002785813, Retrieved from the Internet: URL:https://en.wikipedia.org/w/index.php?title=Electroless_nickel_immersion_gold&direction=next&oldid=786803373 [retrieved on 2018-10-16]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Leiterplatten-Baugruppe.

Leiterplatten sind Träger für elektronische Bauteile. Sie dienen der mechanischen Befestigung und elektrischen Verbindung der Bauteile. Eine Leiterplatten-Baugruppe, deren Oberfläche zumindest teilweise von einer Lötstopplackschicht geschützt ist, ist beispielsweise aus dem Dokument DE 10 2011 082 537 A1 bekannt.

Leiterplatten werden unter unterschiedlichen Umwelteinflüssen eingesetzt und sind teilweise korrosiven Stoffen oder Medien ausgesetzt. Beispielsweise hat der Einsatz einer Leiterplatte mit darauf befestigten Rotorstellungssensoren für die Erfassung der Rotorstellung eines Rotors eines Elektromotors in einem Getriebeöl in Langzeittests zu Problemen mit Korrosion geführt.

Es ist daher eine Aufgabe der Erfindung, eine neue Leiterplatten-Baugruppe bereitzustellen.

Die Erfindung wird gelöst durch den Gegenstand des Anspruchs 1. Das Vorsehen einer Lötstopplackschicht, die sich zumindest bereichsweise von außerhalb des Restringrands über den Restringrand auf einen äußeren Bereich des Restrings erstreckt, wobei am Restring ein innerer Bereich verbleibt, der nicht von der Lötstopplackschicht bedeckt ist, ermöglicht einerseits eine Lötverbindung und andererseits einen erhöhten Korrosionsschutz im Bereich des Restringrands. Dies hat sich insbesondere bei einem Kontakt der Leiterplatten-Baugruppe mit aggressiven Medien als vorteilhaft erwiesen.

Gemäß einer bevorzugten Ausführungsform ist der innere Bereich ringförmig ausgebildet. Hierdurch kann eine gute Lötverbindung erzielt werden.

Gemäß einer bevorzugten Ausführungsform weist der innere Bereich um das Kontaktloch herum zumindest bereichsweise eine radiale Erstreckung von mindestens 0,05 mm auf, bevorzugt von mindestens 0,10 mm, besonders bevorzugt von mindestens 0,30 mm. Hierdurch wird eine ausreichende Fläche für die Lötverbindung bereitgestellt.

Gemäß einer bevorzugten Ausführungsform weist der innere Bereich um das Kontaktloch herum an jeder Stelle eine radiale Erstreckung von mindestens 0,05 mm auf, bevorzugt von mindestens 0,10 mm, besonders bevorzugt von mindestens 0,30 mm. Dies ermöglicht eine sichere Lötverbindung.

Gemäß einer bevorzugten Ausführungsform ist der äußere Bereich ringförmig ausgebildet. Dies ermöglicht einen guten Schutz des Restrings im äußeren Bereich.

Gemäß einer bevorzugten Ausführungsform weist der äußere Bereich um das Kontaktloch herum zumindest bereichsweise eine radiale Erstreckung von mindestens 0,05 mm auf, bevorzugt von mindestens 0,10 mm, besonders bevorzugt von mindestens 0,30 mm. Hierdurch kann ein guter Schutz erzielt werden.

Gemäß einer bevorzugten Ausführungsform weist der äußere Bereich um das Kontaktloch herum an jeder Stelle eine radiale Erstreckung von mindestens 0,05 mm auf, bevorzugt von mindestens 0,10 mm, besonders bevorzugt von mindestens 0,30 mm. Dies ermöglicht einen Schutz des Restrings um den ganzen Umfang herum.

Erfindungsgemäß ist auf mindestens einem Restring eine nickelhaltige Schicht und auf der nickelhaltigen Schicht eine goldhaltige Schicht angebracht, wobei sich die nickelhaltige Schicht und die goldhaltige Schicht zumindest bereichweise in den inneren Bereich und in den äußeren Bereich erstrecken. Durch eine solche Schichtanordnung ergibt sich zusammen mit der Lötstopplackschicht im äußeren Bereich eine sehr korrosionsbeständige Ausführungsform.

Gemäß einer bevorzugten Ausführungsform weist die Leiterplatte eine Leiterbahn auf, welche mit dem äußeren Bereich des Restrings elektrisch verbunden ist. Der geschützte äußere Bereich kann somit für die Verbindung verwendet werden.

Erfindungsgemäß weist die Leiterplatten-Baugruppe ein Bauteil mit einem Kontaktpin auf, welcher Kontaktpin zumindest teilweise in der Durchkontaktierung angeordnet ist, und welche Leiterplatten-Baugruppe ein Lot aufweist, welches Lot mit dem Kontaktpin und mit dem inneren Bereich des Restrings mechanisch und elektrisch verbunden ist. Ein solcher Kontaktpin kann mit dem Lot (Lötmittel) sicher in der Durchkontaktierung befestigt werden.

Gemäß einer bevorzugten Ausführungsform ist das Lot nur mit dem inneren Bereich des Restrings mechanisch verbunden ist. Hierdurch bleibt der äußere Bereich von der Lötstopplackschicht bedeckt.

Ferner ist erfindungsgemäß auf mindestens einer Seite der Leiterplatte eine Schutzschicht aus Gießharz vorgesehen ist, um dort einen Schutz der Leiterplatte zu bewirken. Der Korrosionsschutz kann hierdurch weiter erhöht werden.

Die Erfindung wird auch gelöst durch eine Pumpenanordnung mit einem Elektromotor und einer Pumpe, welcher Elektromotor einen Rotor und einen Stator aufweist, welcher Rotor dazu ausgebildet ist, die Pumpe anzutreiben, welche Pumpenanordnung eine Leiterplatten-Baugruppe aufweist, welche Leiterplatten-Baugruppe mindestens einen Rotorstellungssensor aufweist, welcher mindestens eine Rotorstellungssensor dazu vorgesehen ist, die Rotorstellung des Rotors zu ermitteln, wobei der Rotor und die Leiterplatten-Baugruppe dazu vorgesehen sind, eine Anordnung in dem von der Pumpe zu fördernden Medium zu ermöglichen. In Kombination mit einer solchen Pumpenanordnung ist die Verwendung der Leiterplatten-Baugruppe besonders vorteilhaft, da hierdurch die Pumpenanordnung auch mit sehr aggressiven Medien verwendet werden kann.

Gemäß einer bevorzugten Ausführungsform ist das von der Pumpe zu fördernde Medium ein Öl, insbesondere ein Mineralöl. Solche Medien haben sich als teilweise sehr aggressiv erwiesen, und die Leiterplatten-Baugruppe kann hier besonders bevorzugt eingesetzt werden.

Weitere Einzelheiten und vorteilhafte Weiterbildungen der Erfindung ergeben sich aus den im Folgenden beschriebenen und in den Zeichnungen dargestellten, in keiner Weise als Einschränkung der Erfindung zu verstehenden Ausführungsbeispielen, sowie aus den Unteransprüchen. Es zeigt:

Fig. 1    einen Ausschnitt einer Leiterplatten-Baugruppe in einer Draufsicht,

Fig. 2    den Ausschnitt von Fig. 1 in einem Schnitt entlang der Linie II-II von Fig. 1,

Fig. 3    die Leiterplatten-Baugruppe von Fig. 1 mit einem daran befestigten elektronischen Bauteil,

Fig. 4    eine weitere Ausführungsform der Leiterplatten-Baugruppe mit einer Schutzschicht,

Fig. 5    eine weitere Ausführungsform einer Leiterplatten-Baugruppe mit einer ENIG-Schicht,

Fig. 6    eine weitere Ausführungsform der Leiterplatten-Baugruppe mit einer Schutzschicht,

Fig. 7    eine weitere Ausführungsform einer Leiterplatten-Baugruppe mit unterschiedlichen Restring-Formen,

Fig. 8    eine Leiterplatten-Baugruppe mit einem Korrosionsschaden, und

Fig. 9    ein bevorzugtes Anwendungsbeispiel für die Leiterplatten-Baugruppe.

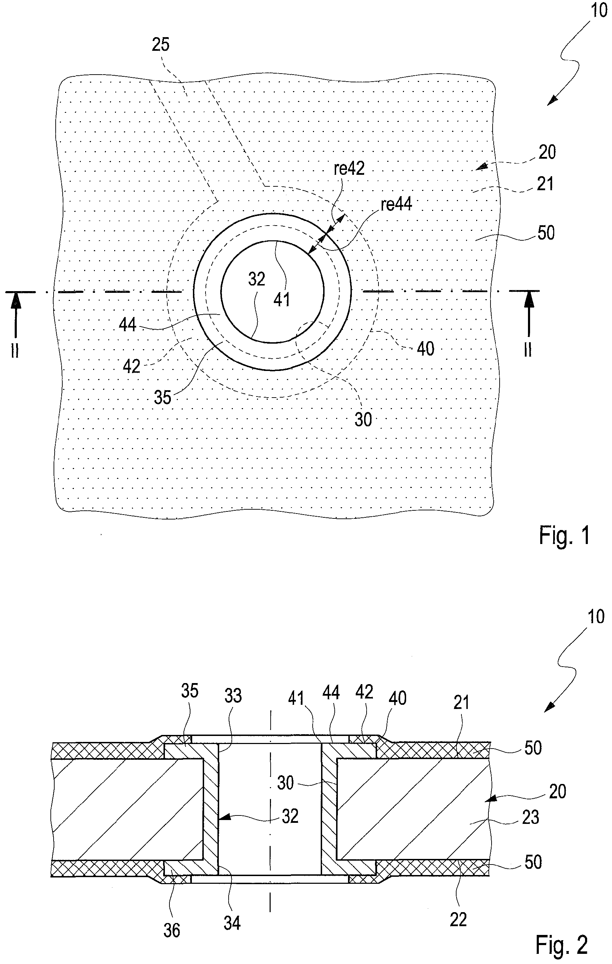

**Fig. 1** zeigt einen Ausschnitt einer Leiterplatten-Baugruppe 10 in einer Draufsicht, und **Fig. 2** zeigt den Ausschnitt der Leiterplatten-Baugruppe 10 in einem Schnitt entlang der Linie II-II von Fig. 1. Die Leiterplatten-Baugruppe 10 hat eine Leiterplatte 20 mit einer ersten Seite 21 und einer zweiten Seite 22. Die Leiterplatte 20 hat ein Substrat 23, das auch als Träger bezeichnet werden kann und üblicherweise aus einem elektrisch isolierenden Material wie Epoxidharz, Teflon oder insbesondere faserverstärktem Epoxidharz hergestellt ist. Die Leiterplatte 20 hat ein Kontaktloch 30, in welchem eine hülsenförmige Durchkontaktierung 32 vorgesehen ist. Der Durchkontaktierung 32 ist an mindestens einer Seite 33 bzw. 34 ein Restring 35 bzw. 36 zugeordnet. Restringe werden auch als Pads oder Lötaugen bezeichnet. Der Restring 35 ist auf der ersten Seite 21 der Leiterplatte 20 angeordnet, und der Restring 36 auf der zweiten Seite 22. Die Restringe 35, 36 sind mit der Durchkontaktierung 32 elektrisch verbunden und weisen zumindest bereichsweise einen Restringrand 40 auf. In Fig. 1 ist zusätzlich zu sehen, dass eine Leiterbahn 25 mit dem ringförmigen Restring 35 verbunden ist. Im Bereich der Leiterbahn 25 ist kein Restringrand 40 vorhanden, da die Leiterbahn 25 direkt mit dem Restring 35 verbunden ist.

Die hülsenförmige Durchkontaktierung 32 und der Restring 35 bzw. 36 sind aus einem elektrisch leitenden Werkstoff (elektrischer Leiter) ausgebildet. Als elektrisch leitender Werkstoff für die Leiterbahn 25, die Durchkontaktierung 32 und die Restringe 35 bzw. 36 kann ein Metall oder eine Metalllegierung, beispielsweise Kupfer oder eine Kupferlegierung (beispielsweise mit Nickel) verwendet werden, in Spezialfällen sind auch Beschichtungen mit Gold oder Silber möglich. Es können auch unterschiedliche Werkstoffe für die Durchkontaktierung 32 und die Restringe 35 bzw. 36 verwendet werden.

Die Leiterplatten-Baugruppe 10 hat auf der ersten Seite 21 und auf der zweiten Seite 22 eine Lötstopplacksicht 50, die im Englischen als solder mask layer bezeichnet werden kann. Die Lötstopplackschicht 50 erstreckt sich im Ausführungsbeispiel von außerhalb des Restringrands 40 über den Restringrand 40 auf einen äußeren Bereich 42 des Restrings 35 bzw. 36, wobei am Restring 35, 36 ein innerer Bereich 44 verbleibt, der nicht von der Lötstopplackschicht 50 bedeckt ist. In Fig. 1 ist die Lötstopplackschicht grafisch hervorgehoben. Im Falle einer lichtdurchlässigen Lötstopplackschicht 50 sieht man bei einer Leiterplatte entsprechend Fig. 1 alle Linien außer der Schnittlinie II — II und der die Lage des Kontaktlochs 30 andeutende Linie.

Es ist auch möglich, die Lötstopplackschicht 50 derart anzubringen, dass sie sich nur bereichsweise von außerhalb des Restringrands 40 über den Restringrand 40 auf den äußeren Bereich 42 des Restrings 35, 36 erstreckt.

Der innere Bereich 44 ist im Ausführungsbeispiel ringförmig ausgebildet. Der innere Bereich 44 hat um das Kontaktloch 30 herum zumindest bereichsweise eine radiale Erstreckung re44 von mindestens 0,05 mm, bevorzugt von mindestens 0,10 mm und besonders bevorzugt von mindestens 0,30 mm. Die radiale Erstreckung re44 wird jeweils vom inneren Restringrand 41 radial nach außen bis zum Beginn der Lötstopplackschicht 50 gemessen. Im Ausführungsbeispiel hat der innere Bereich 44 des Restrings 35 die ringförmige Ausgestaltung von zwei konzentrischen Kreisen, und daher ist die radiale Erstreckung re44 um das Kontaktloch 30 herum an jeder Stelle gleich. In der Praxis wird die radiale Erstreckung re44 jedoch bereichsweise etwas variieren, bspw. durch eine entsprechende Vorgabe der Maske für die Lötstopplackschicht 50 oder durch eine ungenaue Bohrung des Kontaktlochs 30.

Bevorzugt ist der äußere Bereich 42 des Restrings 35 ebenfalls ringförmig ausgebildet. Der äußere Bereich 42 des Restrings, der mit der Lötstopplackschicht 50 beschichtet ist, hat um das Kontaktloch 30 herum bevorzugt zumindest bereichsweise eine radiale Erstreckung von mindestens 0,05 mm, weiter bevorzugt von mindestens 0,10 mm und besonders bevorzugt von mindestens 0,3 mm. Im Ausführungsbeispiel ist der äußere Bereich 42 um das Kontaktloch herum an jeder Stelle gleich, und damit auch die radiale Erstreckung re42 des äußeren Bereich 42.

Der Restring 35 ist im Ausführungsbeispiel mit einer Leiterbahn 25 elektrisch verbunden, wobei die elektrische Verbindung bevorzugt im äußeren Bereich 42 des Restrings 35 vorgesehen ist. Es können auch mehrere Leiterbahnen 25 mit dem Restring 35 elektrisch verbunden sein.

Der innere Bereich 44 des Restrings 35 ist bevorzugt dazu vorgesehen, eine elektrische Verbindung mit einem Pin zu ermöglichen, welcher Pin sich zumindest bereichsweise in das Kontaktloch 30 hinein erstreckt.

Die Lötstopplackschicht 50 schützt in ihrem Bereich vor Korrosion und mechanischer Beschädigung und verhindert beim Löten das Benetzen der Leiterplatte mit dem Lot. Sie ist häufig auf Leiterplatten als grüne Schicht vorgesehen und wird so aufgebracht, dass die Pads (Restringe) und Bauteilanschlüsse frei bleiben. Aufgebracht wird der Stopplack beispielsweise durch Siebdruck, Sprühen oder Vorganggießen.

Das Vorsehen der Lötstopplackschicht 50 bis in den äußeren Bereich 42 des Restrings 35 schützt den Restring 35 insbesondere im Bereich des Restringrands 40.

Wenn die Leiterplatten-Baugruppe 10 bspw. einem aggressiven Medium wie einem Getriebeöl ausgesetzt ist, wird der Restring 35 zumindest im äußeren Bereich 42 durch die Lötstopplackschicht 50 vor dem aggressiven Medium geschützt. Getriebeöl enthält Schwefel und führt damit zu einer erhöhten Korrosion.

Der innere Bereich 44 ist dagegen nicht durch die Lötstopplackschicht 50 bedeckt, und daher kann im inneren Bereich 44 bspw. eine Lötverbindung hergestellt werden.

Im Ausführungsbeispiel wurde die Durchkontaktierung 32 mit einem Lochdurchmesser von 1,2 mm vorgesehen, und die Kupferschicht des Restrings 35 bzw. 36 hat eine Dicke von 35 $\mu$m. Der Durchmesser des Restrings 35 beträgt 2,5 mm, während er üblicherweise ohne das Vorsehen des äußeren Bereichs 42 1,8 mm beträgt. Der innere Bereich 44 hat einen Durchmesser von 1,8 mm, so dass der innere Bereich 44 des Restrings 35 dem üblichen Durchmesser von 1,8 mm entspricht.

Die radiale Erstreckung re44 des inneren Bereichs 44 beträgt somit

$$(1{,}8 \text{ mm} - 1{,}2 \text{ mm})/2 = 0{,}3 \text{ mm}.$$

Die radiale Erstreckung re42 des äußeren Bereichs 42 beträgt somit

$$(2{,}5 \text{ mm} - 1{,}8 \text{ mm})/2 = 0{,}35 \text{ mm}.$$

Die genannten Zahlenwerte sind vorteilhaft, es können aber auch andere Werte verwendet werden. Die Größen sind auch abhängig von den Größen der Pins 14 und den zu erwartenden Stromstärken.

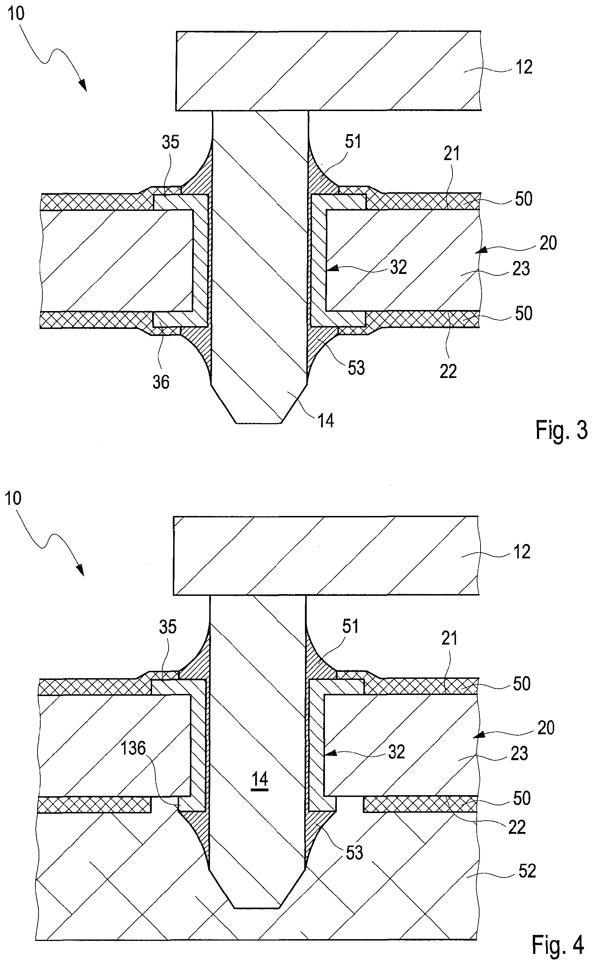

**Fig. 3** zeigt die Leiterplatten-Baugruppe 10 von Fig. 1 und Fig. 2, wobei ein elektrisches oder elektronisches Bauteil 12 mit einem Pin 14 an der Durchkontaktierung 32 mit den Restringen 35, 36 elektrisch verbunden ist. Das Bauteil 12 kann beispielsweise ein Transistor mit drei Pins 14, ein IC mit sechs oder acht Pins 14 oder ein Kontaktstift mit einem oder zwei Pins 14 sein. Kontaktstifte werden beispielsweise dazu verwendet, zwei Leiterplatten elektrisch miteinander zu verbinden, und sie haben an mindestens einer Seite einen Pin 14. An der ersten Seite 21 der Leiterplatte 20 ist eine Lötverbindung mit einem Lot 51 zu sehen, und an der zweiten Seite 22 der Leiterplatte 20 eine Lötverbindung mit einem Lot 53. Die Lötverbindungen haben im Ausführungsbeispiel sowohl Kontakt zum Pin 14 als auch zum inneren Bereich 44 des Restrings 35 bzw. 36. Das Lot 51, 53 der Lötverbindungen erstreckt sich bevorzugt durch das Kontaktloch 30 hindurch im Bereich zwischen dem Pin 14 und der Durchkontaktierung 32. Hierdurch ist eine großflächige Verbindung zwischen dem Pin 14 und der Durchkontaktierung 32 vorhanden und eine sichere Lötverbindung gewährleistet. Das Lot 51, 53 hat im Ausführungsbeispiel im Bereich zwischen dem Pin 14 und dem inneren Bereich 44 des Restrings 35 bzw. 36 eine typische Form, die auch als Lotmeniskus bezeichnet wird. Der äußere Bereich 42 dient als zusätzliche Haltefläche für den Restring 35 und verringert die Gefahr einer Ablösung des Restrings 35.

**Fig. 4** zeigt eine weitere Ausführungsform, bei der die Durchkontaktierung 32 auf der ersten Seite 21 einen Restring 35 aufweist, der teilweise von einer Lötstopplackschicht 50 bedeckt ist, und bei der auf der zweiten Seite 22 ein Restring 136 vorgesehen ist, der von einer zugeordneten Löstopplackschicht 50 beabstandet ist. Zum Schutz der zweiten Seite 22 ist zusätzlich eine Schutzschicht 52 aus einem Gießharz vorgesehen. Als Gießharz kann beispielsweise ein Epoxidharz, ein Copolymerisat aus Polyurethan und Polyacrylat, oder ein Gießharz auf Polyurethanbasis verwendet werden. Gießharze können auf die Leiterplatte gegossen oder geträufelt werden und härten anschließend aus, wobei die Aushärtung bei bestimmten Gießharzen über eine Bestrahlung mit UV-Licht möglich ist. Gießharze werden auch als Dichtschichtlacke bezeichnet. Die Schutzschicht 52 bedeckt bevorzugt die vom Bauteil 22 abgewandte Seite 22 der Leiterplatte 20 zumindest im Bereich offener elektrischer Kontakte, weiter bevorzugt vollständig.

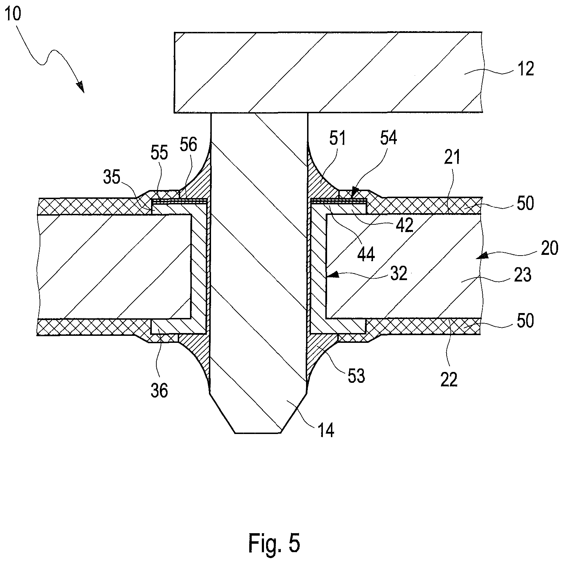

**Fig. 5** zeigt eine weitere Ausführungsform der Leiterplatten-Baugruppe 10. Diese ist weitgehend aufgebaut wie das Ausführungsbeispiel von Figur 3. Zusätzlich ist jedoch auf der ersten Seite 21 der Leiterplatte 20 der Restring 35 mit einer metallischen Beschichtung versehen. Es ist eine sogenannte ENIG-Schicht 54 auf dem Restring 35 vorgesehen. Die ENIG-Schicht 54 hat eine nickelhaltige Schicht 55 auf dem Restring 35, und die nickelhaltige Schicht 55 ist noch einmal mit einer goldhaltigen Schicht 56 beschichtet. Die nickelhaltige Schicht 55 hat üblicherweise eine Dicke im Bereich von 3 bis 6 $\mu$m, und sie enthält bevorzugt Nickel mit einem Massenanteil von mindestens 0,5, weiter bevorzugt von mindestens 0,8. Die goldhaltige Schicht 56 hat üblicherweise eine Dicke im Bereich 0,05 bis 0,10 $\mu$m, und sie enthält bevorzugt Gold mit einem Massenanteil von mindestens 0,5, weiter bevorzugt von mindestens 0,8. Die ENIG-Schicht 54 erlaubt sehr ebene Flächen, und die nickelhaltige Schicht 55 wird durch die dünne goldhaltige Schicht 56 vor Oxidation und Korrosion geschützt. Die nickelhaltige Schicht 55 kann chemisch (stromlos) beschichtet werden, und anschließend kann die goldhaltige Schicht 56 aufgebracht werden. Die Bezeichnung "ENIG" steht für "Electroless Nickel Immersion Gold".

Besonders an der gezeigten ENIG-Schicht 54 ist, dass sich diese sowohl in den inneren Bereich 44 als auch in den äußeren Bereich 42 des Restrings 35 erstreckt. Dies kann dadurch erreicht werden, dass die ENIG-Beschichtung erfolgt, bevor die Lötstopplackschicht 50 angebracht wird. Die gezeigte Anordnung hat den Vorteil, dass auch dann, wenn die Lötstopplackschicht 50 bspw. unvollständig ist oder einen Riss aufweist, der Restring 35 gut vor aggressiven Medien geschützt ist. Würde die ENIG-Schicht dagegen nach der Anbringung der Lötstopplackschicht 50 angebracht werden, wäre nur der innere Bereich 44 des Restrings 35 geschützt.

In gleicher Weise kann naturgemäß auch der Restring 36 mit einer ENIG-Schicht 54 versehen werden, sofern dies erforderlich ist. Wenn jedoch eine zusätzliche Schutzschicht 52 wie in Figur 4 vorgesehen ist, ist es ausreichend, die ENIG-Schicht nur auf der ersten Seite 21 der Leiterplatte 20 vorzusehen.

Die ENIG-Schicht 54 wird bevorzugt auf allen leitenden Elementen auf der entsprechenden Seite der Leiterplatte 20 vorgesehen, also auch auf ggf. vorgesehenen Leiterbahnen 25 (vgl. Fig. 1).

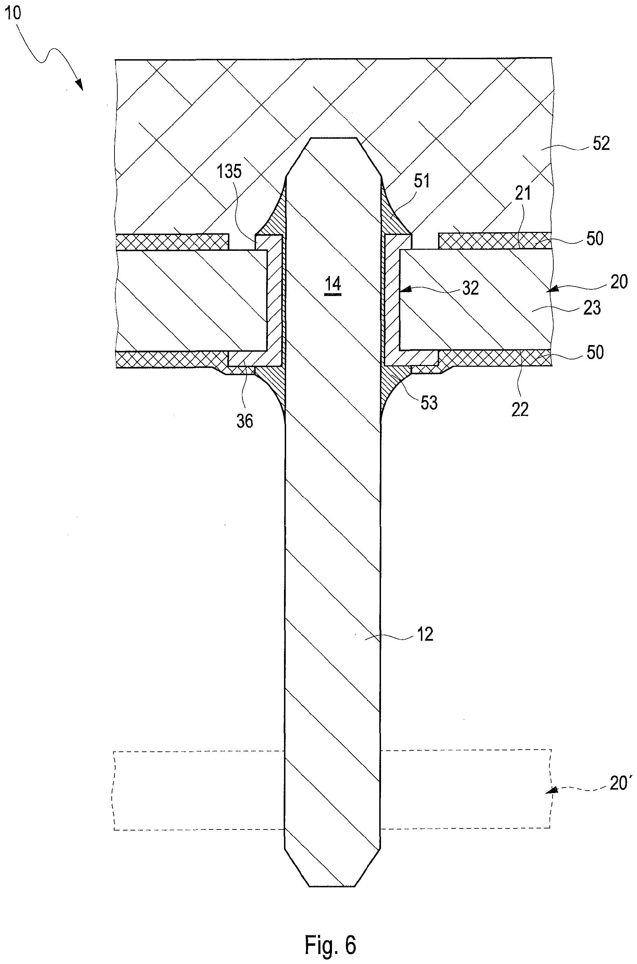

**Fig. 6** zeigt ein weiteres Ausführungsbeispiel für die Leiterplatten-Baugruppe 10. Auf der ersten Seite 21 der Leiterplatte 20 ist ein Restring 135 vorgesehen, der nicht durch eine Lötstopplackschicht 50 geschützt ist, und auf der zweiten Seite 22 der Leiterplatte 20 ist ein durch eine Lötstopplackschicht 50 geschützter Restring 36 vorgesehen. Eine Durchkontaktierung 32 ist vorgesehen. Im Ausführungsbeispiel ist das Bauteil 12 als Kontaktstift mit einem Pin 14 ausgebildet. Solche Kontaktstifte werden beispielsweise zur elektrischen Kontaktierung von zwei Leiterplatten verwendet, und das in Fig. 6 untere Ende kann mit einer schematisch dargestellten zweiten Leiterplatte 20' verbunden werden.

Zur Montage kann bspw. die Leiterplatte 20 auf den Kontaktstift geschoben und anschließend verlötet werden. Bei bestimmten Anwendungsfällen ist der Bereich der zweiten Seite 22 nach dem Verlöten nicht mehr gut zugänglich, bspw., wenn die Leiterplatte 20 gegen ein nicht gezeigtes Gehäuseteil anliegt. In diesem Fall kann die zweite Seite 22 der Leiterplatte 20 nach der Montage nicht mehr vergossen werden. Daher ist es vorteilhaft, in solchen Fällen auf der zweiten Seite 22 einen Restring 36 mit Schutz durch die Lötstopplackschicht 50 vorzusehen. Sofern die erste Seite 21 der Leiterplatte 20 nach der Montage zugänglich ist, kann auf dieser Seite eine Schutzschicht 52 vorgesehen werden, wie dies in Fig. 4 beschrieben ist. Da eine solche Schutzschicht 52 üblicherweise gut vor Korrosion schützt, kann der Restring 135 auf der ersten Seite 21 der Leiterplatte 20 ohne Schutz durch die Lötstopplackschicht 50 ausgebildet werden. Für eine größere Sicherheit kann der Restring auf der ersten Seite 21 jedoch ebenfalls durch eine Lötstopplackschicht 50 geschützt werden.

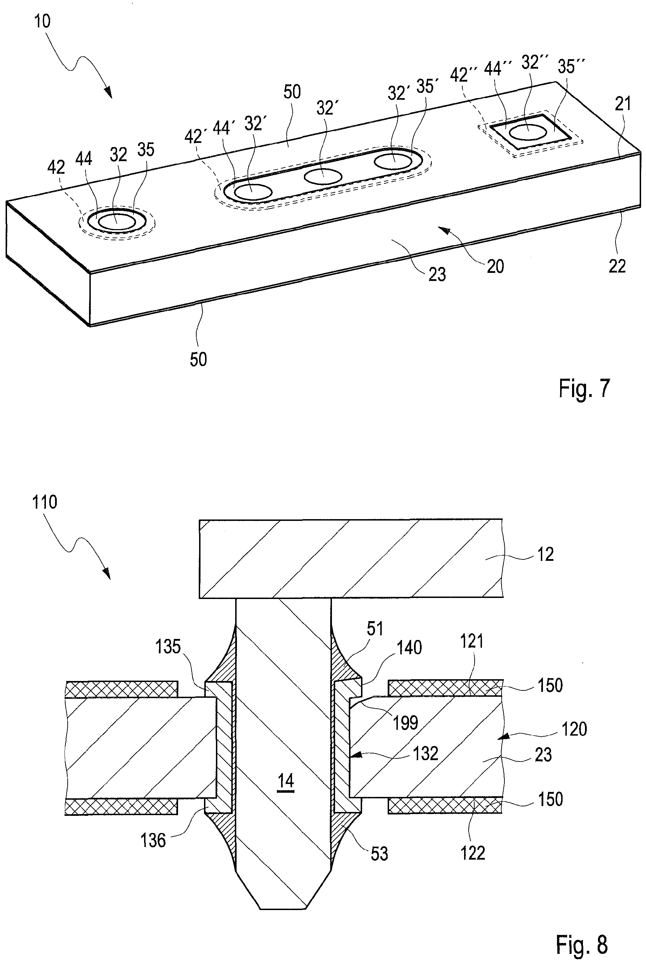

**Fig. 7** zeigt beispielhaft unterschiedliche Geometrien für die Restringe.

Die Durchkontaktierung 32 hat einen Restring 35 mit einem ringförmigen hohlzylindrischen inneren Bereich 44 und einem ringförmigen hohlzylindrischen äußeren Bereich 42.

Die Durchkontaktierungen 32' haben einen gemeinsamen Restring 35' mit einem rechteckförmigen inneren Bereich 44' mit abgerundeten Ecken und einem ringförmigen äußeren Bereich 42' mit rechteckförmiger Kontur und abgerundeten Ecken. Eine solche Ausgestaltung ermöglicht die elektrische Verbindung mehrerer Bauteile untereinander oder aber auch die elektrische Verbindung eines Bauteils mit mehreren Pins für hohe Ströme.

Die Durchkontaktierung 32" hat einen Restring 35 mit einem ringförmigen inneren Bereich 44", der innen eine runde Kontur und außen eine rechteckförmige Kontur hat, und mit einem ringförmigen äußeren Bereich 42", der innen und außen eine rechteckförmige Kontur hat.

Die Form des Restrings 35 somit auch rechteckig, polygonartig, als Zusammenschluss mehrerer nebeneinander liegender Durchkontaktierungen oder mit einer anderen Form ausgeführt werden. Hierbei wird bevorzugt jeweils die Lötstopplackschicht 50 derart vorgesehen, dass die äußere Kontur des Restrings durch die Lötstopplackschicht 50 überzogen ist und den Restring 35 zumindest teilweise überdeckt.

**Fig. 8** zeigt eine Leiterplattenanordnung 110 mit einer Leiterplatte 120 und einer Durchkontaktierung 132 mit einem ersten Restring 135 und einem zweiten Restring 136. Eine Lötstopplackschicht 150 ist auf beiden Seiten 121, 122 der Leiterplatte 120 vorgesehen und hat jeweils einen Abstand vom Restringrand 140 der Restringe 135, 136. Ein solcher Abstand wird üblicherweise vorgegeben, um eine auf Grund der Toleranzen bei der Fertigung der Lötstopplackschicht 150 unerwünschte Überdeckung des Restrings 135 auszuschließen, die eine Lötverbindung im beschichteten Bereich verhindern würde. An einer Stelle 199 ist schematisch ein Schaden der Leiterplattenanordnung 110 angedeutet. Der Restring 135 ist im Bereich 199 angehoben, und dies wird im Englischen als "pad-lifting" bezeichnet. Ein solches Anheben kann bereits beim Verlöten durch die beim Abkühlen der Lötverbindung entstehende Kräfte oder nach dem Verlöten auf Grund unterschiedlicher Wärme-Ausdehnungkoeffizienten der Werkstoffe verursacht werden. Zudem kann ein aggressives Medium in den Bereich zwischen dem Restring 135 und der Leiterplatte 120 eindringen und dort zu Leiterplattenkorrosion, insbesondere zu Kupferkorrosionen und Schäden im Leiterplattenbasismaterial führen.

Besonders gravierende Auswirkungen können entstehen, wenn durch die Korrosion leitfähige Ablagerungen entstehen, die zu Kurzschlüssen zwischen mehreren Kontakten führen.

Bei Tests werden die Leiterplattenanordnungen 110 beispielsweise einem schwefelhaltigen Getriebeöl bei bis zu 140 °C ausgesetzt.

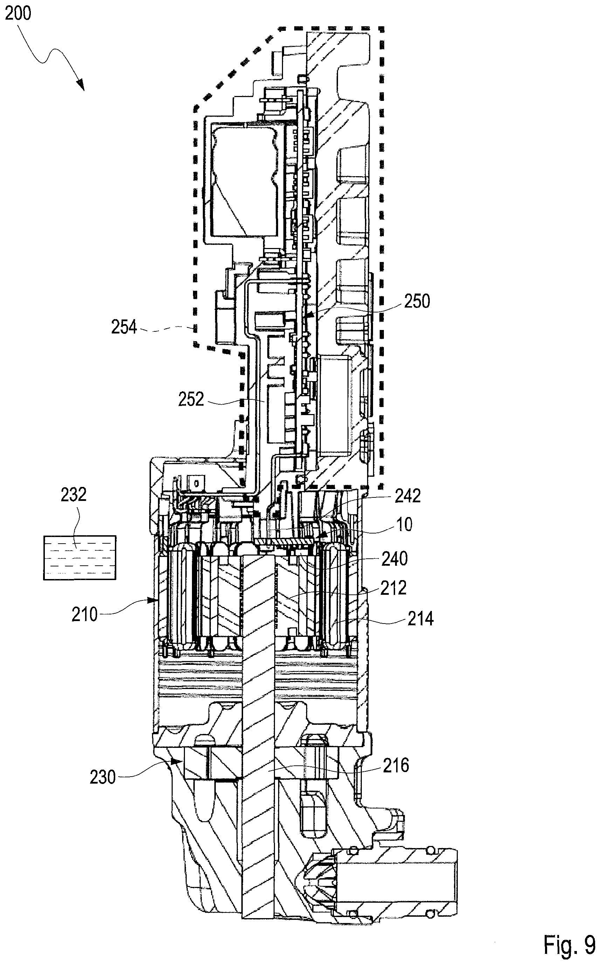

**Fig. 9** zeigt ein bevorzugtes Anwendungsbeispiel für eine Leiterplatten-Baugruppe 10, wie sie in den vorhergehenden Figuren beschrieben wurde. Eine Pumpenanordnung 200 hat einen Elektromotor 210 und eine Pumpe 230. Der Elektromotor 210 hat einen Rotor 212 und einen Stator 214, wobei beispielhaft der Rotor 212 als Innenrotor und der Stator 214 als Außenstator dargestellt sind. Der Rotor 212 ist dazu ausgebildet, die Pumpe 230 anzutreiben. Im Ausführungsbeispiel ist der Rotor 212 über eine Welle 216 mit der Pumpe 230 verbunden, die Drehmomentübertragung kann aber beispielsweise auch über ein Zahnradgetriebe erfolgen. Die Pumpe 230 ist im Ausführungsbeispiel als Gerotor-Pumpe ausgebildet. Es ist aber auch die Verwendung eines anderer Pumpentyps, bspw. eines Strömungspumpe möglich. Die Leiterplatten-Baugruppe 10 hat mindestens einen Rotorstellungssensor 240, bevorzugt drei Rotorstellungssensoren 240. Diese Rotorstellungssensoren 240 sind dazu vorgesehen, die Rotorstellung des Rotors 212 zu ermitteln.

Im Ausführungsbeispiel ist die Steuerelektronik 250 integriert und in einem Gehäuse 252 angeordnet. Der abgedichtete Bereich ist schematisch mit einer Umrandung 254 versehen. Kontaktstifte 272 sind zwischen der Steuerelektronik 250 und der Leiterplatten-Baugruppe 10 vorgesehen und verbinden diese miteinander. Die Kontaktstifte 242 können bspw. im Gehäuse 252 eingespritzt sein, um durch diese Abdichtung ein Eindringen eines zu fördernden Mediums in das Gehäuse 252 zu verhindern. Es sind auch andere Abdichtungsmöglichkeiten bekannt, bspw. mit Hilfe von Gummi-Dichtelementen.

Der Rotor 212 und die Leiterplatten-Baugruppe 10 sind dazu vorgesehen, eine Anordnung in dem von der Pumpe 230 zu fördernden Medium 232 zu ermöglichen. Der Rotor 212 und die Leiterplatten-Baugruppe 10 sind also gegenüber den Bereichen, in denen das Medium 232 ist, nicht abgedichtet. Soweit um den Elektromotor 210 herum ein Gehäuse vorgesehen ist, kann dieses bspw. mit Öffnungen versehen werden, oder der Bereich, durch den sich die Welle erstreckt, kann mit Nuten versehen werden, die einen Durchfluss des zu fördernden Mediums 232 entlang der Welle 216 ermöglichen. Es ist auch möglich, das Gehäuse um den Elektromotor 210 herum weitgehend wegzulassen und nur eine mechanische Verbindung zwischen Elektromotor 210 und Pumpe 230 in Form von Streben vorzusehen. Durch mindestens eine dieser Maßnahmen kann die Anordnung im Medium ermöglicht werden.

Bei der vorliegenden Pumpenanordnung 200 hat sich in Versuchen das Vorsehen der Leiterplatten-Baugruppe 10 als sehr vorteilhaft erwiesen. Die Seite der Leiterplatten-Baugruppe 10 mit den Rotorstellungssensoren 240, also die dem Rotor 212 zugewandte Seite, kann nach dem Verlöten der Leiterplatten-Baugruppe 10 mit den Kontaktstiften 242 mit einem Gießharz geschützt werden. Die vom Rotor 212 abgewandte Seite kann jedoch nach dem Verlöten der Leiterplatten-Baugruppe 10 nicht mehr durch Gießharz geschützt werden, da die abgewandte Seite bereichsweise durch das Gehäuse 252 verdeckt ist. Daher ist auf dieser abgewandten Seite ein Vorsehen der durch die Lötstopplackschicht geschützten Restringe vorteilhaft und führt zu einer korrosionsbeständigen Anordnung. Diese kann auch für die Förderung von Ölen, insbesondere Mineralölen verwendeten werden. In der Praxis hat sich insbesondere Getriebeöl auf Grund des darin enthaltenen Schwefels als sehr korrosiv erwiesen.

Es kann bevorzugt die in Fig. 6 gezeigte und beschriebene Ausführungsform der Leiterplatten-Baugruppe 10 mit ihren optionalen Abwandlungen verwendet werden. Naturgemäß sind im Rahmen der Erfindung vielfältige Modifikationen und Abwandlungen möglich.

Die Leiterplatten 20 in den Ausführungsbeispielen sind einlagig bzw. zweilagig ausgebildet. Die Erfindung kann auch bei Multilayer-Leiterplatten mit Leiterbahnen im Substrat 23 verwendet werden, wobei die Durchkontaktierungen 32 zwei benachbarte oder nicht benachbarte Leiterbahnenschichten elektrisch verbinden können oder aber auch drei oder mehr Leiterbahnenschichten.

### Bezugszeichenliste

| | | | |
|---|---|---|---|
| 10 | Leiterplatten-Baugruppe | 210 | Elektromotor |
| 12 | Bauteil | 212 | Rotor |
| 14 | Pin | 214 | Stator |

(fortgesetzt)

| | | | |
|---|---|---|---|
| 20 | Leiterplatte | 216 | Welle |
| 21 | erste Seite | 230 | Pumpe |
| 22 | zweite Seite | 232 | zu förderndes Medium |
| 23 | Substrat | 240 | Rotorstellungssensor |
| 25 | Leiterbahn | 242 | Kontaktstift |
| 30 | Kontaktloch | 250 | Steuerelektronik |
| 32 | Durchkontaktierung | 252 | Gehäuse |
| 33 | erste Seite | 254 | abgedichteter Bereich |
| 34 | zweite Seite | | |
| 35 | Restring | | |
| 36 | Restring | | |
| 40 | Restringrand außen | | |
| 41 | Restringrand innen | | |
| 42 | äußerer Bereich | | |
| 44 | Innerer Bereich | | |
| 50 | Lötstopplackschicht | | |
| 51 | Lötverbindung | | |
| 52 | Schutzschicht | | |
| 53 | Lötverbindung | | |
| 54 | ENIG-Schicht | | |
| 55 | nickelhaltige Schicht | | |
| 56 | goldhaltige Schicht | | |
| 120 | Leiterplatte | | |
| 140 | Restringrand außen | | |
| 121 | erste Seite | | |
| 132 | Durchkontaktierung | | |
| 133 | erste Seite | | |
| 135 | Restring | | |
| 136 | Restring | | |
| 150 | Lötstopplackschicht | | |
| 200 | Pumpenanordnung | | |

**Patentansprüche**

1.  Leiterplatten-Baugruppe (10) mit einer Leiterplatte (20), welche Leiterplatte (20) eine erste Seite (21), eine zweite Seite (22) und ein Kontaktloch (30) aufweist, in welchem Kontaktloch (30) eine hülsenförmige Durchkontaktierung (32) vorgesehen ist,

    welcher Durchkontaktierung (32) an mindestens einer Seite (33; 34) ein Restring (35; 36) zugeordnet ist, welcher Restring (35; 36) auf der ersten Seite (21) oder auf der zweiten Seite (22) der Leiterplatte (20) angeordnet und mit der Durchkontaktierung (32) elektrisch verbunden ist, welcher Restring (35; 36) zumindest bereichsweise einen Restringrand (40) aufweist,
    welche Leiterplatten-Baugruppe (10) eine Lötstopplackschicht (50) aufweist, welche Lötstopplackschicht (50) sich zumindest bereichsweise von außerhalb des Restringrands (40) über den Restringrand (40) auf einen äußeren Bereich (42) des Restrings (35; 36) erstreckt, wobei am Restring (35; 36) ein innerer Bereich (44) verbleibt, der nicht von der Lötstopplackschicht (50) bedeckt ist, ferner aufweisend ein Bauteil (12; 242) mit einem Kontaktpin (14) und ein Lot (51; 53), welcher Kontaktpin (14) zumindest teilweise in der Durchkontaktierung (32) angeordnet ist, und welches Lot (51; 53) mit dem Kontaktpin (14) und mit dem inneren Bereich (44) des Restrings (35; 36) mechanisch und elektrisch verbunden ist,
    wobei auf mindestens einem Restring (35; 36) eine nickelhaltige Schicht (55) und auf der nickelhaltigen Schicht eine goldhaltige Schicht (56) angebracht ist, wobei sich die nickelhaltige Schicht (55) und die goldhaltige Schicht (56) zumindest bereichsweise in den inneren Bereich (44) und in den äußeren Bereich (42) erstrecken,

wobei auf der zweiten Seite (22) der Leiterplatte (20) eine Schutzschicht (52) aus Gießharz vorgesehen ist, um dort einen Schutz der Leiterplatte (20) zu bewirken.

2. Leiterplatten-Baugruppe nach Anspruch 1, bei welcher der innere Bereich (44) ringförmig ausgebildet ist.

3. Leiterplatten-Baugruppe nach einem der vorhergehenden Ansprüche, bei welcher der innere Bereich (44) um das Kontaktloch (30) herum zumindest bereichsweise eine radiale Erstreckung (re44) von mindestens 0,05 mm aufweist, bevorzugt von mindestens 0,10 mm, besonders bevorzugt von mindestens 0,30 mm.

4. Leiterplatten-Baugruppe nach einem der vorhergehenden Ansprüche, bei welcher der innere Bereich (44) um das Kontaktloch (30) herum an jeder Stelle eine radiale Erstreckung (re44) von mindestens 0,05 mm aufweist, bevorzugt von mindestens 0,10 mm, besonders bevorzugt von mindestens 0,30 mm.

5. Leiterplatten-Baugruppe nach einem der vorhergehenden Ansprüche, bei welcher der äußere Bereich (42) ringförmig ausgebildet ist.

6. Leiterplatten-Baugruppe nach einem der vorhergehenden Ansprüche, bei welcher der äußere Bereich (42) um das Kontaktloch (30) herum zumindest bereichsweise eine radiale Erstreckung (re42) von mindestens 0,05 mm aufweist, bevorzugt von mindestens 0,10 mm, besonders bevorzugt von mindestens 0,30 mm.

7. Leiterplatten-Baugruppe nach einem der vorhergehenden Ansprüche, bei welcher der äußere Bereich (42) um das Kontaktloch (30) herum an jeder Stelle eine radiale Erstreckung (re42) von mindestens 0,05 mm aufweist, bevorzugt von mindestens 0,10 mm, besonders bevorzugt von mindestens 0,30 mm.

8. Leiterplatten-Baugruppe nach einem der vorhergehenden Ansprüche, bei welcher die Leiterplatte (20) eine Leiterbahn (25) aufweist, welche mit dem äußeren Bereich (42) des Restrings (35) elektrisch verbunden ist.

9. Leiterplatten-Baugruppe nach einem der vorhergehenden Ansprüche, bei welcher das Lot (51; 53) nur mit dem inneren Bereich (44) des Restrings (35; 36) mechanisch verbunden ist.

10. Pumpenanordnung (200) mit einem Elektromotor (210) und einer Pumpe (230), welcher Elektromotor (210) einen Rotor (212) und einen Stator (214) aufweist, welcher Rotor (212) dazu ausgebildet ist, die Pumpe (230) anzutreiben, welche Pumpenanordnung (200) eine Leiterplatten-Baugruppe (10) nach einem der vorhergehenden Ansprüche aufweist,

welche Leiterplatten-Baugruppe (10) mindestens einen Rotorstellungssensor (240) aufweist,
welcher mindestens eine Rotorstellungssensor (240) dazu vorgesehen ist, die Rotorstellung des Rotors (212) zu ermitteln,
wobei der Rotor (212) und die Leiterplatten-Baugruppe (10) dazu vorgesehen sind, eine Anordnung in dem von der Pumpe (230) zu fördernden Medium (232) zu ermöglichen.

11. Pumpenanordnung nach Anspruch 10,
bei welcher das von der Pumpe zu fördernde Medium ein Öl ist, insbesondere ein Mineralöl.

**Claims**

1. A printed circuit board assembly (10) having a printed circuit board (20),

said printed circuit board (20) having a first side (21), a second side (22) and a contact hole (30), a sleeve-type via (32) being provided in the contact hole (30),
an annular ring (35; 36) being associated with said sleeve-type via (32) on at least one side (33; 34), said annular ring (35; 36) being disposed on the first side (21) or on the second side (22) of the printed circuit board (20) and electrically connected to said sleeve-type via (32), said annular ring (35; 36) at least in sections comprising an annular ring edge (40),
said printed circuit board module (10) comprising a solder resist layer (50), the solder resist layer (50) extending at least in sections from outside the annular ring edge (40) over the annular ring edge (40) to an outer region (42) of the annular ring (35; 36), wherein an inner region (44), which is not covered by the solder resist layer (50), remains on the annular ring (35; 36),
further comprising a component (12; 242) having a contact pin (14) and a solder (51; 53), said contact pin (14) being at least partially disposed in said sleeve-type via (32), and said solder (51; 53) being mechanically and electrically connected to the contact pin (14) and to the inner region (44) of the annular ring (35; 36).
wherein a nickel-containing layer (55) is applied to at least one annular ring (35; 36) and a gold-containing layer (56) is applied to the nickel-containing layer, wherein the nickel-containing layer (55) and the gold-containing layer (56) extend at least in sections into the inner region (44) and into the outer region (42),
wherein a protective layer (52) made of casting resin is provided on at least one side (21; 22) of the printed circuit board (20) to ensure protection of the printed circuit board (20).

2. The printed circuit board assembly according to claim 1, wherein the inner region (44) is ring-shaped.

3. The printed circuit board assembly according to any one of the preceding claims, wherein the inner region (44) around the contact hole (30), at least in sections, has a radial extension (re44) of at least 0.05 mm, preferably of at least 0.10 mm, particularly preferably of at least 0.30 mm.

4. The printed circuit board assembly according to any one of the preceding claims, wherein the inner region (44) around the contact hole (30), at each point, has a radial extension (re44) of at least 0.05 mm, preferably of at least 0.10 mm, particularly preferably of at least 0.30 mm.

5. The printed circuit board assembly according to any one of the preceding claims, wherein the outer region (42) is ring-shaped.

6. The printed circuit board assembly according to any one of the preceding claims, wherein the outer region (42) around the contact hole (30), at least in sections, has a radial extension (re42) of at least 0.05 mm, preferably of at least 0.10 mm, particularly preferably of at least 0.30 mm.

7. The printed circuit board assembly according to any one of the preceding claims, wherein the outer region (42) around the contact hole (30), at each point, has a radial extension (re42) of at least 0.05 mm, preferably of at least 0.10 mm, particularly preferably of at least 0.30 mm.

8. The printed circuit board assembly according to any one of the preceding claims, wherein the printed circuit board (20) comprises a conductive path (25) which is electrically connected to the outer region (42) of the annular ring (35).

9. The printed circuit board assembly according to any one of the preceding claims, wherein the solder (51; 53) is only mechanically connected to the inner region (44) of the annular ring (35; 36).

10. A pump assembly (200) having an electric motor (210) and a pump (230), said electric motor (210) comprising a rotor (212) and a stator (214), said rotor (212) being formed to drive said pump (230),

said pump assembly (200) comprising a printed circuit board assembly (10) according to any one of the preceding claims,
said printed circuit board assembly (10) comprising at least one rotor position sensor (240),
said at least one rotor position sensor (240) being provided to determine the rotor position of said rotor (212),
wherein said rotor (212) and said printed circuit board assembly (10) are provided to allow arrangement in the medium (232) to be delivered by said pump (230).

11. The pump arrangement according to claim 10,
wherein the medium to be delivered by the pump is an oil, particularly a mineral oil.


**Revendications**

1. Ensemble de carte de circuits imprimés (10), comprenant une carte de circuits imprimés (20), laquelle carte de circuits imprimés (20) présente une première face (21), une deuxième face (22) et un trou de contact (30) dans lequel trou de contact (30) est prévu un dispositif d'interconnexion (32) en forme de douille,

lequel dispositif d'interconnexion (32) est associé sur au moins une face (33 ; 34) à une collerette (35 ; 36), laquelle collerette (35 ; 36) est disposée sur la première face (21) ou sur la deuxième face (22) de la carte de circuits imprimés (20) et est reliée électriquement au dispositif d'interconnexion (32), laquelle collerette (35 ; 36) présente au moins par endroits un bord de collerette (40),

lequel ensemble de carte de circuits imprimés (10) présente une couche de vernis épargne (50), laquelle couche de vernis épargne (50) s'étend au moins par endroits de l'extérieur du bord de collerette (40) par le bord de collerette (40) sur une zone extérieure (42) de la collerette (35 ; 36), dans lequel, sur la collerette (35 ; 36), il reste une zone intérieure (44) qui n'est pas recouverte par la couche de vernis épargne (50), présentant en outre un composant (12 ; 242) muni d'une broche de contact (14) et un métal d'apport (51 ; 53), laquelle broche de contact (14) est disposée au moins par endroits dans le dispositif d'interconnexion (32), et lequel métal d'apport (51 ; 53) est relié mécaniquement et électriquement à la broche de contact (14) et à la zone intérieure (44) de la collerette (35 ; 36),

une couche contenant du nickel (55) étant appliquée sur au moins une collerette (35 ; 36), et une couche contenant de l'or (56) étant appliquée sur la couche contenant du nickel, la couche contenant du nickel (55) et la couche contenant de l'or (56) s'étendant au moins par endroits dans la zone intérieure (44) et dans la zone extérieure (42),

une couche de protection (52) en résine coulée étant prévue sur la deuxième face (22) de la carte de circuits imprimés (20) afin de provoquer une protection de la carte de circuits imprimés (20) à cet endroit.

2. Ensemble de carte de circuits imprimés selon la revendication 1, dans lequel la zone intérieure (44) est réalisée en forme d'anneau.

3. Ensemble de carte de circuits imprimés selon l'une quelconque des revendications précédentes, dans lequel la zone intérieure (44) présente autour du trou de contact (30) au moins par endroits une extension radiale (re44) d'au moins 0,05 mm, de préférence d'au moins 0,10 mm, de manière particulièrement préférée d'au moins 0,30 mm.

4. Ensemble de carte de circuits imprimés selon l'une quelconque des revendications précédentes, dans lequel la zone intérieure (44) présente autour du trou de contact (30) en tout endroit une extension radiale (re44) d'au moins 0,05 mm, de préférence d'au moins 0,10 mm, de manière particulièrement préférée d'au moins 0,30 mm.

5. Ensemble de carte de circuits imprimés selon l'une quelconque des revendications précédentes, dans lequel la zone extérieure (42) est réalisée en forme d'anneau.

6. Ensemble de carte de circuits imprimés selon l'une quelconque des revendications précédentes, dans lequel la zone extérieure (42) présente autour du trou de contact (30) au moins par endroits une extension radiale (re42) d'au moins 0,05 mm, de préférence d'au moins 0,10 mm, de manière particulièrement préférée d'au moins 0,30 mm.

7. Ensemble de carte de circuits imprimés selon l'une quelconque des revendications précédentes, dans lequel la zone extérieure (42) présente autour du trou de contact (30) en tout endroit une extension radiale (re42) d'au moins 0,05 mm, de préférence d'au moins 0,10 mm, de manière particulièrement préférée d'au moins 0,30 mm.

8. Ensemble de carte de circuits imprimés selon l'une quelconque des revendications précédentes, dans lequel la carte de circuits imprimés (20) présente une piste conductrice (25) qui est reliée électriquement à la zone extérieure (42) de la collerette (35).

9. Ensemble de carte de circuits imprimés selon l'une quelconque des revendications précédentes, dans lequel le métal d'apport (51 ; 53) est relié mécaniquement uniquement à la zone intérieure (44) de la collerette (35 ; 36).

10. Ensemble de pompe (200) comprenant un moteur électrique (210) et une pompe (230), lequel moteur électrique (210) présente un rotor (212) et un stator (214),

lequel rotor (212) est réalisé pour entraîner la pompe (230),
lequel ensemble de pompe (200) présente un ensemble de carte de circuits imprimés (10) selon l'une quelconque des revendications précédentes,
lequel ensemble de carte de circuits imprimés (10) présente au moins un capteur de position de rotor (240),
lequel au moins un capteur de position de rotor (24) est prévu pour déterminer la position de rotor du rotor (212),
le rotor (212) et l'ensemble de carte de circuits imprimés (10) étant prévus pour permettre un agencement dans le fluide (232) à débiter par la pompe (230).

11. Ensemble de pompe selon la revendication 10, dans lequel le fluide à débiter par la pompe est de l'huile, en particulier de l'huile minérale.

Fig. 1

Fig. 2

10

12

35

51

21

50

20

23

32

50

22

53

14

36

Fig. 3

10

12

35

51

21

50

20

23

32

136

14

50

22

53

52

Fig. 4

Fig. 5

Fig. 6

Fig. 7

Fig. 8

Fig. 9

**IN DER BESCHREIBUNG AUFGEFÜHRTE DOKUMENTE**

**In der Beschreibung aufgeführte Patentdokumente**

- DE 102011082537 A1